# FASCICULE DE BREVET EUROPEEN

(11) **EP 0 327 412 B1**
(45) Date de publication et mention de la délivrance du brevet: **21.09.1994**
(21) Numéro de dépôt: 89400042.1
(22) Date de dépôt: 06.01.1989
(51) Int. Cl.: H01L 23/28, H01L 21/314, H01L 21/56

(54) **Procédé de passivation d'un circuit intégré**
Passivierungsverfahren für eine integrierte Schaltung
Passivation process of a integrated circuit

(30) Priorité: 13.01.1988 FR 8800294
(43) Date de publication de la demande: 09.08.1989
(73) Titulaire: SGS-THOMSON MICROELECTRONICS S.A., 94250 Gentilly (FR)
(72) Inventeur: Merenda, Pierre, F-75116 Paris (FR); Genot, Bernard, F-75116 Paris (FR)
(74) Mandataire: Ballot, Paul Denis Jacques

(56) Documents cités:
- EP-A- 0 034 455
- DE-A- 3 030 862
- FR-A- 2 382 095
- GB-A- 1 566 072
- US-A- 4 198 444
- PATENT ABSTRACTS OF JAPAN, vol. 11, no. 77 (E-487)(2524), 7 mars 1987 ; & JP-A-61 232 646
- PATENT ABSTRACTS OF JAPAN, vol. 7, no. 166 (E-188)(1311), 21 juillet 1983 ; & JP-A-58 074 043
- RADIO, FERNSEHEN, ELEKTRONIK, vol. 32, no. 2, février 1983, page 68, Ost-Berlin, DDR ; "Die doppelte Glaspassivierung".
- THIN SOLID FILMS, vol. 83, no. 2, septembre 1981, pages 145-163, Lausanne, Suisse ; A.M. WILSON : "Polyimide Insulators for Multilevel Interconnections".
- PATENT ABSTRACTS OF JAPAN, vol. 6, no. 170 (E-128)(1048), 3 septembre 1982 ; & JP-A-57 088 734
- PATENT ABSTRACTS OF JAPAN, vol. 10, no. 251 (E-432)(2307), 28 août 1986 ; & JP-A-61 079 233
- PATENT ABSTRACTS OF JAPAN, vol. 7, no. 49 (E-161)(1194), 25 février 1983 ; & JP-A-57 199 224
- PATENT ABSTRACTS OF JAPAN, vol. 6, no. 99 (E-111)(977), 8 juin 1982 ; & JP-A-57 031 145
- PATENT ABSTRACTS OF JAPAN, vol. 10, no. 356 (E-459)(2412), 29 novembre 1986 ; & JP-A-61 154 131

## Description

La présente invention concerne un nouveau procédé de passivation de circuits intégrés.

En effet, dans les circuits intégrés, il est habituel de recouvrir les surfaces actives d'une couche de passivation ou couche de protection dont le but est d'éviter les pollutions pouvant altérer les caractéristiques des composants formant le circuit intégré. Cette couche est constituée par un diélectrique stable tel que du dioxyde de silicium, du nitrure de silicium ou un oxynitrure de silicium. Les matériaux employés comme diélectrique présentent l'inconvénient d'être relativement durs. Cette caractéristique entraîne des risques de fissures de la couche de passivation, ces fissures pouvant se propager jusque vers les surfaces actives. Il en résulte que la couche de passivation ne joue plus son rôle de protection.

D'autre part, les couches de passivation sont généralement déposées sur la dernière couche de métallisation. La couche de métallisation est gravée pour réaliser les conducteurs métalliques. En général, la gravure est réalisée sous plasma réactif. Elle est pratiquement anisotrope et s'effectue dans le sens de l'épaisseur de la couche. Il en résulte que les conducteurs présentent une section approximativement rectangulaire. Aussi, lorsque l'on dépose la couche de passivation sur les conducteurs, on s'aperçoit que la couche de passivation ne se dépose pas de manière uniforme mais présente une structure vallonnée avec des creux particulièrement importants au niveau des bords des conducteurs.

JP-A-61-232646 (voir PATENT ABSTRACTS OF JAPAN Vol.11 Number 77 (E-487)(2524)) concerne la réduction des contraintes thermiques entre une résine de protection et une couche de protection, en insérant entre elles deux couches de SiO₂ ou SiN₄ séparées par une couche qui absorbe ces contraintes thermiques. Cette couche est à faible élasticité.

La présente invention a pour but de remédier aux inconvénients mentionnés ci-dessus.

Elle a pour objet un nouveau procédé de passivation d'un circuit intégré comprenant la formation d'au moins une couche diélectrique finale, caractérisé en ce qu'il consiste à déposer sur le circuit intégré une première couche d'un matériau diélectrique dur, à déposer sur cette couche, une couche d'un matériau diélectrique tendre et à déposer sur la surface ainsi obtenue une deuxième couche d'un matériau diélectrique dur.

L'utilisation d'une couche tendre permet de remplir les vallonnements de la couche en matériau diélectrique dur inférieur et d'obtenir une surface relativement plane sur laquelle on peut déposer facilement une deuxième couche de protection en matériau diélectrique dur. Cette couche tendre intercalée entre deux couches dures permet d'absorber les contraintes mécaniques venant de l'extérieur et évite notamment la propagation des fissures qui auraient pu se réaliser dans les couches en matériau diélectrique dur. De plus, la couche dure externe empêche la déformation plastique de la couche tendre et répartit les contraintes extérieures dans la couche tendre. Par couche dure ou couche tendre dans la présente invention, on entend une couche définie par une mesure de microdureté. Ainsi, une couche dure présentera une dureté supérieure à 700 HK (HK = dureté knoop) (dureté mesurée à 15 g sur film mince de quelques micromètres, déposé sur une plaquette de silicium). Une couche tendre présentera une dureté inférieure à 400 HK.

Selon une autre caractéristique de la présente invention, on réalise de plus, une ou plusieurs fois les étapes suivantes : à savoir, on recouvre la dernière couche diélectrique d'une couche diélectrique tendre, puis l'on dépose sur cette nouvelle couche une couche d'un matériau diélectrique dur. En utilisant ce procédé, on réalise une structure de type "mille feuille" intercalant des couches diélectriques dures avec des couches diélectriques tendres ce qui permet une meilleure absorption des contraintes et un blocage de la transmission des fissures.

Selon un mode de réalisation préférentiel, la couche tendre est obtenue à partir d'une suspension visqueuse que l'on soumet à un recuit.

D'autre part, selon encore une autre caractéristique de la présente invention, on élimine la suspension diélectrique une fois recuite sur une certaine épaisseur de manière à obtenir une surface supérieure plane.

De préférence, la suspension diélectrique est constituée par un gel à base de silice minérale qui sera avantageusement sous forme colloïdale, tel que le gel appelé couramment S.O.G (pour Spin On Glass en langue anglaise) bien connu dans la technique.

Eventuellement, la couche tendre peut être réalisée par une couche de polyimide, mais celle-ci présente l'inconvénient d'avoir une épaisseur importante.

D'autre part, la couche en matériau diélectrique dur sera constituée par un matériau tel que le dioxyde de silicium SiO₂, le nitrure de silicium Si₃ N₄ ou un oxy-nitrure de silicium de la forme SiOₓN_{y}.

D'autres caractéristiques et avantages de la présente invention apparaîtront à la lecture de la description d'un mode de réalisation faite avec référence aux dessins ci-annexés et dans lesquels :
- la figure 1 est une vue en coupe schématique d'un circuit intégré comportant une couche de passivation réalisée conformément à l'art antérieur,
- la figure 2 est une vue en coupe par AA des deux couches supérieures de la figure 1,
- les figures 3A à 3E sont des vues analogues à celles de la figure 2, illustrant les étapes essentielles du procédé de passivation conforme à l'invention et,
- la figure 4 est une vue analogue à celle de la figure 3B représentant une variante du procédé de passivation conforme à la présente invention.

Pour permettre une meilleure compréhension du procédé de la présente invention, les différentes couches ont été représentées à une échelle agrandie et sans respecter leurs dimensions.

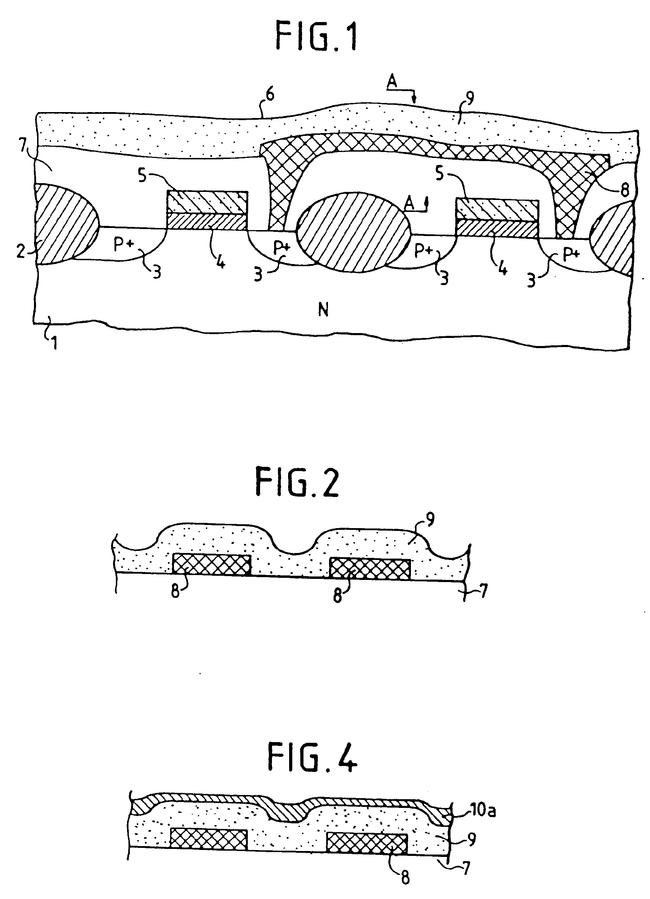

Le circuit intégré représenté sur la figure 1 se compose d'un substrat semiconducteur 1, par exemple un substrat en silicium de type N dans lequel ont été réalisées des zones d'isolement entre les composants constituées, par exemple, par de l'oxyde épais 2 et des zones diffusées 3 telles que par exemple des zones dopées P+. Sur le substrat ont été réalisées des zones d'oxyde mince 4 qui ont été recouvertes par exemple de grilles 5 réalisées en silicium polycristallin. Les différentes zones ci-dessus ont été obtenues en utilisant les procédés classiques bien connus de l'homme de l'art. Ces différentes zones ont été recouvertes d'une couche d'isolement 7 réalisée par exemple en dioxyde de silicium SiO₂. Le circuit représenté sur la figure 1 à titre d'exemple illustratif est constitué de deux transistors MOS de type N. Pour réaliser la connexion entre différentes zones telles que, par exemple, entre deux diffusions correspondantes des deux transistors MOS (Metal Oxyde Semi-conducteur) représentée sur la figure 1, la couche 7 a été gravée de manière connue et une couche métallique 8 a été déposée sur la couche isolante 7. Cette couche métallique est réalisée, par exemple, en aluminium. Les conducteurs sont ensuite réalisés par gravure, en plaçant la couche métallique sous plasma réactif. Cette gravure est en général anisotrope. Elle s'effectue dans le sens de l'épaisseur de la couche et donne ainsi au conducteur une section approximativement rectangulaire comme représenté sur la figure 2.

Si le circuit possède un seul niveau d'interconnexions, les conducteurs 8 sont alors recouverts d'une couche de passivation ou couche de protection qui peut être réalisée en oxyde de silicium Si O₂, en nitrure de silicium Si₃ N₄ ou en oxynitrure de silicium Si Oₓ N_{y}. Le matériau utilisé pour réaliser cette couche de passivation 9 est un matériau dur qui peut se fracturer suite à des contraintes comme représenté par la référence 6 sur la figure 1. D'autre part, en particulier en technologie MOS où plusieurs couches de matériaux différents sont superposées et gravées, la couche de passivation présente un profil vallonné.

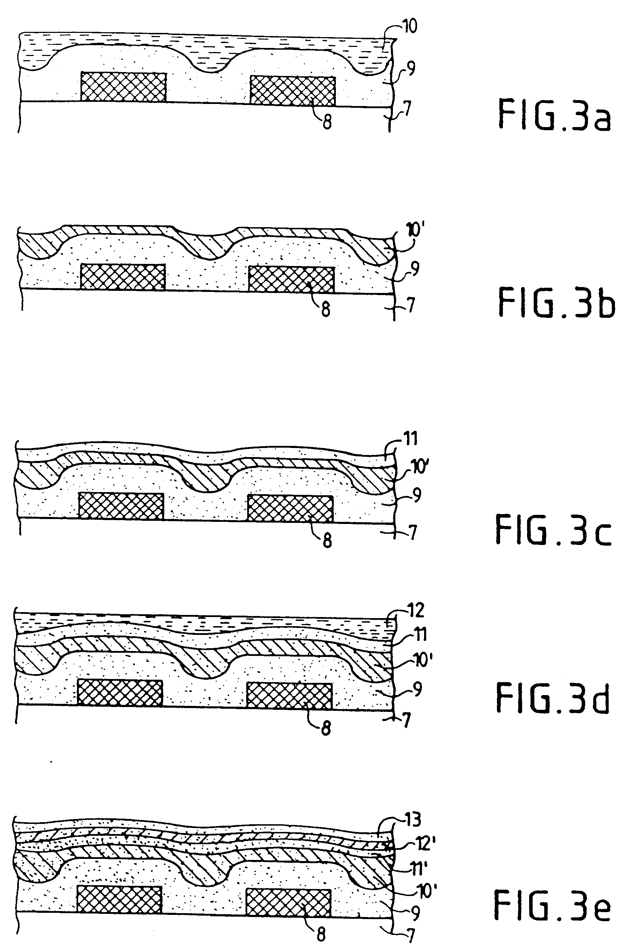

On décrira maintenant, avec référence aux figures 3A à 3E, les différentes étapes du procédé de passivation d'un circuit intégré conforme à la présente invention dans le cas où la couche tendre est obtenue à partir d'une suspension diélectrique visqueuse soumise à un recuit. Ce cas correspond à un mode de réalisation particulièrement avantageux de la présente invention. Le procédé consiste à déposer sur la couche vallonnée 9 une suspension diélectrique visqueuse 10. Cette suspension est étalée de manière uniforme sur toute la surface de la couche diélectrique 9. Du fait, de sa viscosité cette suspension comble totalement les creux existants et forme une couche mince sur toute la surface de la couche diélectrique 9.

A titre d'exemple, la suspension utilisée peut être un gel à base de silice minérale avantageusement sous forme colloïdale tel que le gel appelé couramment S.O.G. (Spin On Glass) bien connu de l'homme de l'art. Dans ce cas, la suspension diélectrique s'utilise de la même manière que les résines photosensibles servant à la configuration des éléments du circuit intégré. On procède ensuite au recuit de la suspension 10. Ce recuit est réalisé pendant 1/2 heure à 425°C. Ainsi, le solvant de la suspension s'évapore tandis que le diélectrique forme une masse compacte 10′ telle que représentée sur la figure 3B. Cette masse forme un film mince sur la couche diélectrique 9 située au-dessus des conducteurs 8. Ensuite, cette couche est recouverte d'une autre couche 11 de matériau diélectrique dur tel que du nitrure de silicium, du dioxyde de silicium ou de l'oxynitrure de silicium. De manière connue, cette couche diélectrique est déposée en utilisant un procédé de dépôt chimique en phase vapeur bien connu de l'homme de l'art.

A titre d'exemple, la couche 9 présente une épaisseur d'environ 500 nm, la couche 10 une épaisseur d'environ 300 nm et la couche 11 une épaisseur d'environ 12 00 nm. Les épaisseurs des couches 9 et 11 peuvent être modifiées à condition que leur somme soit constante et égale à 1 700 nm ± 3 00 nm.

L'utilisation pour la couche de passivation d'une structure composite constituée d'une première couche diélectrique dure 9 recouvrant les conducteurs 8 puis d'une couche tendre en un matériau diélectrique visqueux qui a été recuit, cette couche étant recouverte d'une autre couche d'un matériau diélectrique dur, permet d'absorber les contraintes engendrées sur le circuit et évite la propagation des fissures à l'intérieur du circuit intégré.

De plus, la surface du circuit intégré présente un vallonnement moins accentué, car la couche tendre remplie partiellement les vallonnements de la première couche dure.

Selon une variante de réalisation représentée à la figure 4, pour obtenir une surface supérieure encore plus plane, il est possible d'éliminer uniformément une pellicule d'épaisseur faible de la couche diélectrique 10′ en mettant cette couche sous plasma réactif. Il en résulte une surface 10 presque plane.

Pour améliorer l'absorption des contraintes extérieures et éviter la propagation de fentes à l'intérieur de la couche de passivation, la couche diélectrique dure supérieure 11 peut être à nouveau recouverte d'une suspension diélectrique visqueuse. Cette couche est soumise alors à un recuit pour obtenir la couche 12′ sur la figure 3E. Cette couche 12′ est à nouveau recouverte d'une couche d'un matériau diélectrique dur 13. Les matériaux utilisés pour la couche visqueuse 12 et la couche diélectrique dure 13 sont identiques aux matériaux déjà utilisés pour les couches diélectriques dures 9 et 11 et pour la couche visqueuse 10. Cette superposition de couches donne une structure de type "millefeuille" et peut être renouvelée une ou plusieurs fois. Elle permet d'obtenir une surface supérieure relativement plane et améliore l'absorption des contraintes.

## Revendications

1. Procédé de passivation d'un circuit intégré comprenant la formation d'au moins une couche diélectrique finale, caractérisé en ce qu'il consiste à déposer une première couche (9) d'un matériau diélectrique dur, à déposer sur cette couche, une couche d'un matériau diélectrique tendre (10) obtenue à partir d'une suspension visqueuse que l'on soumet à un recuit et à déposer sur la surface ainsi obtenue une deuxième couche (11) d'un matériau diélectrique dur.

2. Procédé selon la revendication 1, caractérisé en ce qu'on réalise de plus, une ou plusieurs fois les étapes suivantes :
- Recouvrement de la dernière couche de diélectrique dur par une couche diélectrique tendre (12), puis
- dépôt d'une couche (13) d'un matériau diélectrique dur de manière à réaliser une structure de type "millefeuille".

3. Procédé selon l'une quelconque des revendications 1 et 2, caractérisé en ce que la couche tendre est une couche de polyimide.

4. Procédé selon la revendication 1, 2 ou 3 caractérisé en ce qu'on élimine la suspension diélectrique recuite sur une certaine épaisseur de manière à obtenir une surface supérieure plane.

5. Procédé selon l'une quelconque des revendications 1 à 4, caractérisé en ce que la suspension diélectrique est un gel à base de silice minérale, avantageusement sous forme colloïdale.

6. Procédé selon l'une quelconque des revendications 1 à 5, caractérisé en ce que la couche en matériau diélectrique dur est une couche de Si0₂, Si₃N₄, Si0xNy.

7. Circuit intégré comprenant au moins une couche de passivation finale, caractérisé en ce que cette couche comprend une première couche d'un matériau diélectrique dur (9), une première couche d'un matériau diélectrique tendre (10) obtenue à partir d'une suspension visqueuse soumise à un circuit, et une deuxième couche (11) d'un matériau diélectrique dur.

8. Circuit intégré selon la revendication 7, caractérisé en ce que la couche (10) en matériau diélectrique tendre a une épaisseur voisine de 300 nm.

9. Circuit intégré selon la revendication 7 ou 8, caractérisé en ce que les première (10) et deuxième (11) couches en matériau dur ont une épaisseur variable dont la somme est constante et égale à 1700 nm ± 300 nm.

10. Circuit intégré selon la revendication 9, caractérisé en ce que la première couche (9) en matériau diélectrique dur a une épaisseur voisine de 500 nm et en ce que la deuxième couche (11) en matériau diélectrique dur a une épaisseur voisine de 1200 nm.

## Patentansprüche

1. Passivierungsverfahren für eine integrierte Schaltung, umfassend die Bildung von wenigstens einer dielektrischen Endschicht, **dadurch gekennzeichnet,** daß es darin besteht, eine erste Schicht (9) aus einem harten dielektrischen Material aufzubringen, auf dieser Schicht eine Schicht (10) aus einem weichen dielektrischen Material aufzubringen, erhalten aus einer viskosen Suspension, die man einem Tempern unterzieht, und auf der so erzielten Oberfläche eine zweite Schicht (11) aus einem harten dielektrischen Material aufzubringen.

2. Verfahren nach Anspruch 1, dadurch gekennzeichnet, daß man außerdem einmal oder mehrmals die folgenden Schritte durchführt:
- Beschichtung der letzten Schicht aus hartem Dielektrikum durch eine weiche dielektrische Schicht (12), dann
- Aufbringen einer Schicht (13) eines harten dielektrischen Materials, um eine Struktur des Typs "Blätterteig" ("millefeuille") herzustellen.

3. Verfahren nach einem der Ansprüche 1 und 2, dadurch gekennzeichnet, daß die weiche Schicht eine Polyimidschicht ist.

4. Verfahren nach Anspruch 1, 2 oder 3, dadurch gekennzeichnet, daß man die getemperte dielektrische Suspension über eine bestimmte Dicke entfernt, um eine plane obere Fläche zu erhalten.

5. Verfahren nach einem der Ansprüche 1 bis 4, dadurch gekennzeichnet, daß die dielektrische Suspension ein Gel auf der Basis von mineralischem Siliciumdioxid ist, vorteilhafterweise in kolloidaler Form.

6. Verfahren nach einem der Ansprüche 1 bis 5, dadurch gekennzeichnet, daß die Schicht aus hartem dielektrischem Material eine Schicht aus SiO₂, Si₃N₄, SiOxNy ist.

7. Integrierte Schaltung, umfassend wenigstens eine Passivierungsendschicht, dadurch gekennzeichnet, daß diese Schicht eine erste Schicht aus einem harten dielektrischen Material (9), eine erste Schicht aus einem weichen dielektrischen Material (10) aus einer einem Tempern unterzogen viskosen Suspension und eine zweite Schicht (11) aus einem harten dielektrischen Material umfaßt.

8. Integrierte Schaltung nach Anspruch 7, dadurch gekennzeichnet, daß die Schicht (10) aus hartem dielektrischem Material eine Dicke von ungefähr 300 nm hat.

9. Integrierte Schaltung nach Anspruch 7 oder 8, dadurch gekennzeichnet, daß die erste (10) und die zweite (11) Schicht aus hartem Material eine variable Dicke haben, deren Summe konstant und gleich 1700 nm ± 300 nm ist.

10. Integrierte Schaltung nach Anspruch 9, dadurch gekennzeichnet, daß die erste Schicht (9) aus hartem dielektrischem Material eine Dicke von ungefähr 500 nm hat und dadurch, daß die zweite Schicht (11) aus hartem dielektrischem Material eine Dicke von ungefähr 1200 nm hat.

## Claims

1. Method of passivating an integrated circuit comprising the formation of at least one final dielectric layer, characterised in that it consists of depositing a first layer (9) of a hard dielectric material, depositing on this layer a layer of a soft dielectric material (10) obtained from a viscous suspension which is subjected to baking, and depositing on the surface thus obtained a second layer (11) of a hard dielectric material.

2. Method according to Claim 1, characterised in that, in addition, the following steps are carried out one or more times:
- covering the last hard dielectric layer with a soft dielectric layer (12), and then
- depositing a layer (13) of a hard dielectric material so as to produce a structure of the "millefeuille" type.

3. Method according to either one of Claims 1 and 2, characterised in that the soft layer is a layer of polyimide.

4. Method according to Claim 1, 2 or 3, characterised in that the baked dielectric suspension is eliminated over a certain thickness so as to obtain a plane top surface.

5. Method according to any one of Claims 1 to 4, characterised in that the dielectric suspension is a gel based on mineral silica, advantageously in a colloidal form.

6. Method according to any one of Claims 1 to 5, characterised in that the layer of hard dielectric material is a layer of SiO₂, Si₃N₄ or SiOₓN_{y}.

7. Integrated circuit comprising at least one final passivation layer, characterised in that this layer comprises a first layer of hard dielectric material (9), a first layer of soft dielectric material (10) obtained from a viscous suspension subjected to a circuit, and a second layer (11) of hard dielectric material.

8. Integrated circuit according to Claim 7, characterised in that the layer (10) of soft dielectric material has a thickness of around 300 nm.

9. Integrated circuit according to Claim 7 or 8, characterised in that the first (10) and second (11) layers of hard material have a variable thickness, the sum of which is constant and equal to 1700 nm ± 300 nm.

10. Integrated circuit according to Claim 9, characterised in that the first layer (9) of hard dielectric material has a thickness of around 500 nm and in that the second layer (11) of hard dielectric material has a thickness of around 1200 nm.
